(19) **Europäisches Patentamt / European Patent Office / Office européen des brevets**

(11) **EP 1 545 038 B1**

(12) **EUROPEAN PATENT SPECIFICATION**

(45) Date of publication and mention
of the grant of the patent:
**14.02.2007 Bulletin 2007/07**

(51) Int Cl.:
*H04L 1/06* (2006.01)       *H03M 13/45* (2006.01)
*H03M 13/29* (2006.01)       *H04L 1/00* (2006.01)

(21) Application number: **03293222.0**

(22) Date of filing: **18.12.2003**

(54) **Method for interpreting transmitted symbols allowing an iterative adaptation of a basic list of symbols**

Verfahren zur Deutung übertragenen Symbole, die eine wiederholende Anpassung einer grundlegenden Liste von Symbolen erlaubt

Méthode pour interpréter des symboles transmis permettant une adaptation itérative d'une liste fondamentale de symboles

(84) Designated Contracting States:
**AT BE BG CH CY CZ DE DK EE ES FI FR GB GR HU IE IT LI LU MC NL PT RO SE SI SK TR**

(43) Date of publication of application:
**22.06.2005 Bulletin 2005/25**

(73) Proprietors:
- **Mitsubishi Electric Information Technology Centre**
  **Europe B.V.**
  **1119 NS Schiphol Rijk (NL)**
- **MITSUBISHI DENKI KABUSHIKI KAISHA**
  **Chiyoda-ku**
  **Tokyo 100-8310 (JP)**

(72) Inventors:
- **Gresset, Nicolas,**
  **Mitsubishi Electric ITE**
  **35708 Rennes Cedex 7 (FR)**
- **Brunel, Loic,**
  **Mitsubishi Electric ITE**
  **35708 Rennes Cedex 7 (FR)**
- **Boutros, Joseph,**
  **Ecole Sup. des Télécommunications**
  **75013 Paris (FR)**

(74) Representative: **Saint-Marc-Etienne, Christophe**
**Andréas**
**Cabinet Le Guen & Maillet,**
**5, place Newquay, B.P. 70250**
**35802 Dinard Cedex (FR)**

(56) References cited:
**US-A1- 2003 076 890**

- **BOUTROS J J ET AL: "Bit-interleaved coded modulations for multiple-input multiple-output channels" IEEE 6TH SYMP. ON SPREAD-SPECTRUM TECH. APPLI., NJIT, vol. 1, 6 September 2000 (2000-09-06), - 8 September 2000 (2000-09-08) pages 123-126, XP010517534 NEW JERSEY, USA**
- **REID A B ET AL: "List detection for multi-access channels" GLOBECOM'02. 2002 - IEEE GLOBAL TELECOMMUNICATIONS CONFERENCE. CONFERENCE PROCEEDINGS. TAIPEI, TAIWAN, NOV. 17 - 21, 2002, IEEE GLOBAL TELECOMMUNICATIONS CONFERENCE, NEW YORK, NY : IEEE, US, vol. VOL. 1 OF 3, 17 November 2002 (2002-11-17), pages 1083-1087, XP010636313 ISBN: 0-7803-7632-3**
- **GUEGUEN A: "Comparison of suboptimal iterative space-time receivers" 57TH IEEE SEMIANNUAL VEHICULAR TECHNOLOGY CONFERENCE, 22 April 2003 (2003-04-22), - 25 April 2003 (2003-04-25) pages 842-846 vol.2, XP002287833 PISCATAWAY, NJ, USA ISBN: 0-7803-7757-5**
- **HOCHWALD B M ET AL: "ACHIEVING NEAR-CAPACITY ON A MULTIPLE-ANTENNA CHANNEL" IEEE TRANSACTIONS ON COMMUNICATIONS, IEEE INC. NEW YORK, US, vol. 51, no. 3, March 2003 (2003-03), pages 389-399, XP001163616 ISSN: 0090-6778**

**Description**

The present invention relates to a method for interpreting at least one signal transmitted by means of at least one transmitting antenna and received by means of at least one receiving antenna, which method includes:

- a symbol listing step for producing a list of symbols selected among predetermined symbols which may potentially be received by means of said at least one receiving antenna, each listed symbol being represented by at least one bit,
- a marginalization step for processing said listed symbols in order to produce at least one interleaved probability value to be associated to said at least one bit, and
- a de-interleaving step for transforming said at least one interleaved probability value into at least one de-interleaved probability value
- a decoding step for refining said at least one de-interleaved probability value by taking into account knowledge pertaining to an encoding scheme used for encoding the received signal, a refined probability value produced in the course of the decoding step being intended to be used, after being interleaved during an interleaving step, as an *a priori* probability value during a subsequent marginalization step.

Such an interpreting method may be used in telecommunication systems in which multiple antennas are used at a receiver end and/or at a transmitter end of a wireless link, which systems are called Multiple Input Multiple Output systems (further referred to as MIMO systems). MIMO systems have been shown to offer large transmission capacities compared to those offered by single antenna systems. In particular, MIMO capacity increases linearly with the number of transmitting or receiving antennas, whichever the smallest, for a given Signal-to-Noise Ratio and under favourable uncorrelated channel conditions. MIMO techniques are thus likely to be used in future wireless systems intended to provide large spectral efficiencies or, alternatively, reduce the transmitting power required for obtaining a spectral efficiency equivalent to that which is obtained in current telecommunication systems. Such MIMO techniques will very likely be combined with multi-carrier modulation techniques like OFDM (standing for Orthogonal Frequency Division Multiplex) and MC-CDMA (standing for MultiCarrier-Code Division Multiple Access) techniques, whose use in future wireless systems is also considered.

A particular type of MIMO systems makes use of a Bit Interleaved Coded Modulation technique, further referred to as BICM, according to which the transmitter includes a channel encoder intended to apply an encoding, e.g. by means of a convolutional code or of a turbo code, to uncoded data bits, and to provide a binary stream to an interleaver. This interleaver will then deliver permutated bits, which are to be divided into word sequences intended to be transformed into a series of coded symbols featuring each a plurality of components, the components of a same symbol being intended to be transmitted during a same time chip by respective transmitting antennas.

Transmitted symbols are to be interpreted on the receiver end, which is usually performed in MIMO systems of the BICM type by means of an iterative space-time interpreting process, which iterative process is intended to produce estimates of the original uncoded data bits on the basis of which the transmitted symbols have been generated. The spatial diversity induced by the use of multiple transmitting and receiving antennas eases such a decoding, since this diversity provides a larger amount of information than that which would be provided by a single signal transmitted through a single communication channel.

It is well known to use an iterative *a posteriori* probability decoding technique in a MIMO telecommunication system, a marginalisation intended to produce probability values and a decoding to refine the probability values as it is disclosed in the IEEE article entitled "BIT-INTERLEAVED CODED MODULATIONS FOR MULTIPLE-INPUT MULTIPLE-OUTPUT CHANNELS" of J.Boutros and in the IEEE article entitled "COMPARISON OF SUBOPTIMAL ITERATIVE SPACE-TIME RECEIVERS" authored by A.Guéguen.

Commonly used iterative interpreting methods require an initial creation, during a symbol listing step, of a limited list of symbols to which initial probability values are to be associated during a subsequent marginalization step. The initial probability value associated with a given listed symbol may for example consist in a metric representing the distance between the given listed symbol and the received symbol. The probability values thus obtained may be refined by making use, in a subsequent decoding step, of additional knowledge pertaining to the encoding scheme which has been used originally for encoding the received signal. The refined probability value produced for each bit belonging to a same set of bits representative of all listed symbols by such a decoding step may then be used, in an *a posteriori* or, preferably, in an extrinsic form from which *a priori* information related to each bit under consideration has been individually removed, for constituting *a priori* information to be taken into account in addition to the above-described metrics during execution of another marginalization step in a subsequent iteration of the iterative interpreting method.

The inventors have observed occurences of situations in which a refined probability value associated with a given bit conflicts with the original probability value formerly associated with said given bit in the course of the marginalization step. In other terms, the probability for this bit to have a given value may for example appear higher than 0.5 at the end of the marginalization step, whereas the refined probability for this bit to have this same given value will appear lower than 0.5 at the end of the decoding step.

Such conflicting situations may prevent the iterative interpreting process from converging towards a stable final interpretation of a transmitted symbol, and will for sure lengthen the iterative process since multiple iterations will be required for smoothing out all contradictions. Conflicting situations as described above thus produce significant adverse effects on the performance of the system.

The inventors have observed that, though conflicting situations as described above may be caused by adverse conditions affecting the wireless link through which the received signal has been transmitted, particularly by noise having a significant level, other conflicting situations, further referred to as artificial discrepancies, are due to the fact that the list of symbols is generated automatically and may thus contain an insufficient number of symbols for the population constituted by the listed symbols to offer the diversity required for said population to be statistically significant.

Such artificial discrepancies do not reflect any kind of physical phenomenon and carry no informational content, whereas their smoothing out will require processing power and moreover involves an inefficient expenditure of energy, which is in limited supply in a battery-powered receiving device.

The invention aims at solving this problem, by providing an interpreting method in which artificial discrepancies between original and refined probability values are to be suppressed thanks to corrective interventions in the iterative process described above.

Indeed, a method according to the opening paragraph is characterized according to the invention in that it further includes:

- a discrepancy detection step for detecting situations in which probability values associated with a same given bit and produced in the course of the marginalization step, on the one hand, and in the course of the decoding step, on the other hand, are respectively smaller than and greater than 0.5 or *vice-versa,* and
- a list enlarging step for correcting a detected discrepancy by adding at least one additional symbol to the list produced by the symbol listing step.

The invention allows to correct artificial discrepancies, and thus to prevent them from producing significant adverse effects on an iterative interpreting process, by means of a discrepancy detection and of a subsequent increase of the size of the population on the basis of which the original probability values are computed, which population increase aims at eliminating the statistical cause which may have led to the appearance of the detected discrepancy.

According to a specific embodiment of the invention, said at least one additional symbol is obtained by identifying at least one original symbol for which a discrepancy has been detected in relation with a given bit and complementing, within said original symbol, at least said given bit.

The original symbol will usually be obtained by taking a hard decision on the basis of the probability values produced in the course of the marginalization step.

Such an embodiment of the invention aims at adding to the listed symbols at least one non-listed symbol featuring, for the given bit to which conflicting probability values have been associated, a value corresponding to the refined probability produced in the course of the decoding step, which will cause the next probability value produced in the course of the marginalization step to converge towards said refined probability value, if the detected discrepancy is artificial, i.e. if it is linked to purely statistical causes, the above corrective process being iterative according to the general principle of the invention.

As explained above, this embodiment of the invention will allow to create, in the case of an artificial discrepancy, a harmonization process aiming at a convergence between the probability values produced in the course of the marginalization step and the refined probability values produced in the course of the decoding step. The choice of the additional symbol or symbols to be added to the list of symbols produced by the listing step may, however, have an impact on the speed of convergence, and thus on the performance of the iterative interpreting process according to the invention.

A symbol often referred to as maximal *a priori* symbol, obtained by taking a hard decision on the basis of the refined probability values produced in the course of the decoding step may be systematically added to the list of symbols if said maximal *a priori* symbol isn't already included in said list, with advantages that will be described later in further detail.

A prior knowledge of all other symbols of the lattice constellation may advantageously be used for selecting the additional symbol to be added to the list of symbols, in order to enhance the performance of the interpreting method according to this embodiment of the invention.

According to a variant of the specific embodiment of the invention described above, the additional symbol to be added to the list of symbols will be constituted by a particular symbol of the lattice constellation belonging to a population for which said given bit features the suitable complemented value, while being the member of said population which is the closest to the original symbol.

The distance separating the original symbol and the additional symbol may be construed as an Euclidian distance or as a distance in the Hamming sense.

The list enlarging step may be executed automatically as soon as a discrepancy is detected, but should advantageously be triggered selectively only in a situation in which the detected discrepancy is substantial, e.g. only if a difference between a probability value produced in the course of the marginalization step and a corresponding refined probability value produced in the course of the decoding step exceeds a predetermined threshold.

A selective triggering of the list enlarging step will enable to discount small differences in interpretation between the marginalization step and the decoding step, which should be smoothed out in subsequent iterations without requiring any intervention, and will thus save computing time and power.

The inventors have observed that decoding means intended to carry out the decoding step may output integer refined probability values, even if all probability values provided to said decoding means are of a non-integer nature. Such situations may occur due to approximations which will be made during the computational process leading to the refined probability values. Such non-integer refined probability values are indicative of irrevocable decisions and may have an adverse impact on the performance of the iterative interpreting process and lead to errors in the interpretation of the transmitted symbol.

According to another aspect of the invention, a method as described above may thus advantageously also include :

- an integer refined probability detection step for detecting situations in which at least one refined probability value produced by the decoding step is an integer value, and
- a thresholding step for replacing such an integer refined probability value by a predetermined non-integer threshold value.

Such a variant of the invention guarantees that no integer probability values will be left free to damage the soft-decision iterative interpreting process described above, since they will automatically be replaced by non-integer values. The threshold value may for example be chosen equal to 1-δ if the integer refined probability value is 1 and equal to δ if the integer refined probability value is 0, where δ is a predetermined non-integer value chosen lower than 0.5.

According to one of its harware-related aspects, the invention also relates to a telecommunication system including at least one transmitter provided with at least one transmitting antenna and at least one receiver provided with at least one receiving antenna, which receiver includes:

- symbol listing means for producing a list of symbols selected among predetermined symbols which may potentially be received by means of said at least one receiving antenna, each listed symbol being represented by at least one bit,
- marginalization means for processing said listed symbols in order to produce at least one interleaved probability value to be associated to said at least one bit, and
- de-interleaving means for transforming said at least one interleaved probability value into at least one de-interleaved probability value
- decoding means for refining said at least one de-interleaved probability value by taking into account knowledge pertaining to an encoding scheme used for encoding the received signal, a refined probability value produced in the course of the decoding step being intended to be used, after being interleaved during an interleaving step, as an *a priori* probability value during a subsequent marginalization step,

telecommunication system characterized in that the receiver further includes:

- discrepancy detection means for detecting situations in which probability values associated with a same given bit and produced by the marginalization means, on the one hand, and by the decoding means, on the other hand, are respectively smaller than and greater than 0.5 or *vice-versa,* and
- list enlarging means for correcting a detected discrepancy by adding at least one additional symbol to the list produced by the symbol listing means.

According to another of its hardware-related aspects, the invention also relates to a communication device provided with at least one receiving antenna and including:

- symbol listing means for producing a list of symbols selected among predetermined symbols which may potentially be received by means of said at least one receiving antenna, each listed symbol being represented by at least one bit,
- marginalization means for processing said listed symbols in order to produce at least one interleaved probability value to be associated to said at least one bit, and
- de-interleaving means for transforming said at least one interleaved probability value into at least one de-interleaved probability value
- decoding means for refining said at least one probability value by taking into account knowledge pertaining to an encoding scheme used for encoding the received signal, a refined probability value produced in the course of the decoding step being intended to be used, after being interleaved during an interleaving step, as an *a priori* probability value during a subsequent marginalization step,

which communication device further includes :

- discrepancy detection means for detecting situations in which probability values associated with a same given bit and produced by the marginalization means, on the one hand, and by the decoding means, on the other hand, are respectively smaller than and greater than 0.5 or *vice-versa,* and
- list enlarging means for correcting a detected discrepancy by adding at least one additional symbol to the list produced by the symbol listing means.

The characteristics of the invention mentioned above, as well as others, will emerge more clearly from a reading of the following description given in relation to the accompanying figures, amongst which:

Fig.1 is a block diagram showing a highly simplified MIMO telecommunication system in which an interpreting method according to the invention may advantageously be used;
Fig.2 is a diagram showing an original lattice constellation formed by transmitted symbols at a transmitting end and a transformed lattice constellation formed by symbols which may represent the transmitted symbols at a receiving end;
Fig.3 is a diagram depicting a symbol listing step carried out in an interpreting method according to the invention; and
Fig 4 is a diagram depicting an iterative interpreting method according to an advantageous embodiment of the invention.

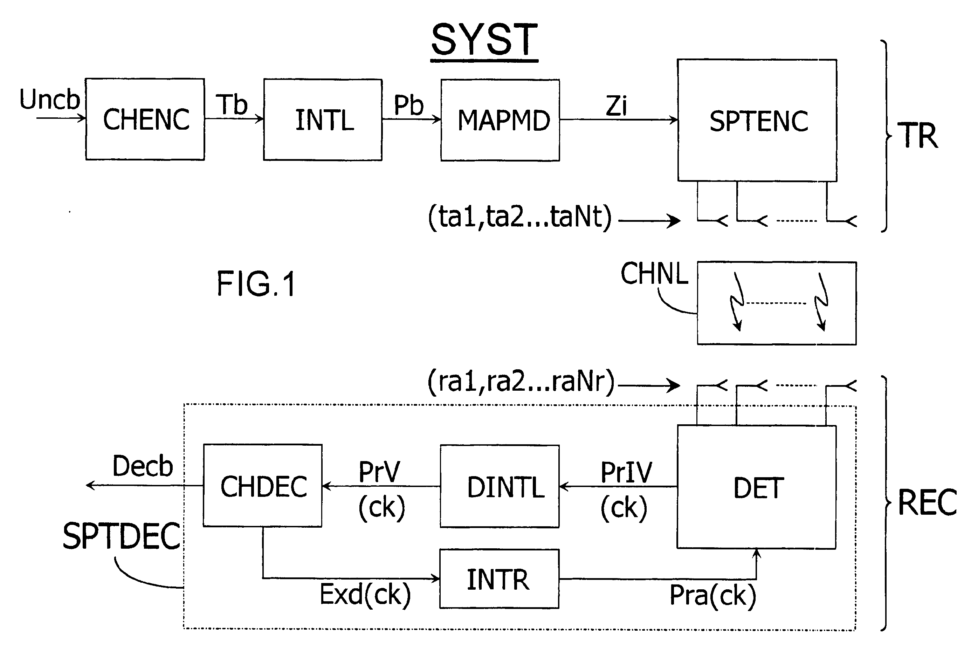

Fig.1 diagrammatically shows a telecommunication system including at least one transmitter TR and one receiver REC, intended to exchange signals through multiple communication channels CHNL established between Nt transmitting and Nr receiving antennas (ta1,ta2...taNt) and (ra1,ra2...raNr), respectively.

The transmitter TR shown in the example depicted here includes a channel encoder CHENC intended to apply an encoding, e.g. by means of a convolutional code or of a turbo code, to uncoded data bits Uncb, and to provide a binary stream Tb to be transmitted. The transmitter TR includes an interleaver INTL intended to generate permutated bits Pb, such an interleaving being useful for a later processing on the receiver side, since it will allow to obtain uncorrelated data. The permutated bits Pb are then divided into sequences of Nt words of at least one bit each, which word sequences are then mapped, i.e. transformed into a series of coded symbols Zi by a mapping and modulation module MAPMD, each symbol Zi then featuring Nt components. Successive symbols Zi are then fed to symbol encoding means essentially formed by a space-time encoder SPTENC, which performs a processing of said symbols Zi before their transmission.

In the known state of the art, the Nt components of each symbol Zi are intended to be transmitted during a same time chip by respective transmitting antennas (ta1,ta2... taNt).

The receiver REC shown in the example depicted here includes a space-time decoder SPTDEC intended to produce decoded data bits Decb which should ultimately correspond to the originally uncoded data bits Uncb. This space-time decoder SPTDEC includes a space-time detector DET intended to process data carried by signals received by means of the receiving antennas (ra1,ra2...raNr), and to produce probability values PrIV(ck) related to estimates of the transmitted permutated bits Pb, which probability values are intended to be de-interleaved by a de-interleaver DINTL which is to output soft probability values PrV(ck) related to estimates of bits included in the binary stream Tb. A bit decoder included in the receiver REC, further referred to as channel decoder CHDEC, is intended to generate the decoded data bits Decb on the basis of said probability values PrV(ck). Indeed, this channel decoder CHDEC will make use of prior knowledge pertaining to the encoding scheme used by the channel encoder CHENC included in the transmitter TR for encoding the data bits Uncb, which prior knowledge will enable said channel decoder CHDEC to refine the probability values PrV(ck) delivered by the space-time detector DET via the de-interleaver DINTL.

According to a looped structure commonly used in the art, the space-time detector DET will make use of *a priori* information Pra(ck) generated in the course of previous decoding steps, and delivered by the channel decoder CHDEC in the form of extrinsic information Exd(ck) representative of said refined probability values through an interleaver INTR, which interleaver is identical to the interleaver INTL included in the transmitter TR.

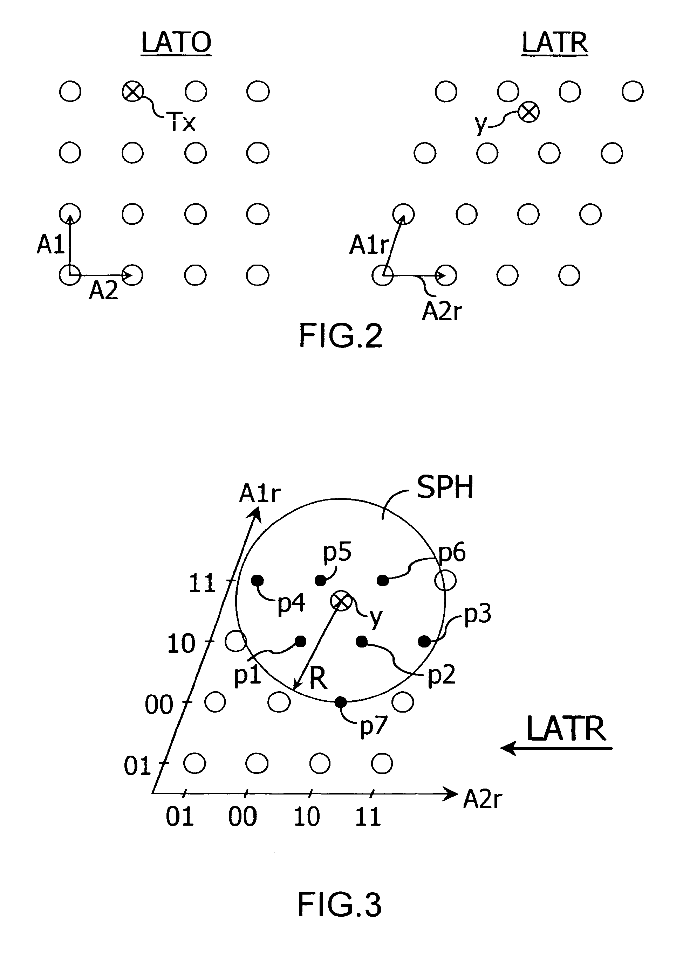

Fig.2 shows in two dimensions an original lattice constellation LATO constituted by symbols which may be transmitted by a transmitter as described above, and a second lattice constellation LATR constituted by symbols which may potentially be received by means of a receiver as described above. The original lattice constellation LATO is defined by a first basic vector system (A1, A2), the second lattice constellation LATR being defined by a second basic vector system (A1r, A2r), which is usually different from the first one because of channel communication conditions affecting signals exchanged between the transmitter and the receiver. Moreover, it appears that though a transmitted symbol Tx is by nature located on a point of the original lattice constellation LATO, a corresponding received symbol y is usually not located on a point of the second lattice constellation LATR because of noise affecting the communication channels established between the transmitter and the receiver.

If Y is a vector representative of the received symbol y, B a vector representative of a symbol originally transmitted, C a matrix representative of the channel or channels through which said symbol has been transmitted and N a vector representative of the noise affecting said communication channel or channels, the above explanations may be mathematically expressed by the equation: Y=C.B+N

Symbol decoding means at the receiver end are intended to provide a list of estimated symbols belonging to the second lattice constellation LATR, which estimated symbols may represent the transmitted symbol Tx. A metric representing the distance between the received symbol y and a given estimated symbol of the lattice constellation may be computed in order to provide a probability value associated with said estimated symbol. In order to limit the extent of the search for such estimated symbols, only the most likely symbols of the second lattice constellation LATR are to be examined, i.e. those symbols who are the closest to the received symbol y.

Fig.3 shows how such a limitation of the search for estimated symbols may be performed advantageously thanks to a particular listing scheme, according to which only those symbols pj (for j=1 to 7) which are included in a sphere SPH having a predetermined radius R will be included in the list produced in the course of the symbol listing step.

In such a symbol listing step, the sphere SPH may either be centered on the received symbol y, as is the case in the embodiment of the invention shown here, or may also be centered on a particular symbol MLP of the lattice constellation LATR, which symbol MLP will previously have been identified as being the most likely representative of the received symbol y.

The inventors have observed that situations may occur, in which the listed symbols produced by the symbol listing step are such that at least one of the bits representing the listed symbols is almost invariant among said listed symbols.

Such will be the case, in the example depicted here, if p1 is represented by 1000, p2 by 1010, p3 by 1011, p4 by 1101, p5 by 1100, p6 by 1110, and p7 by 0010, in which situation a first bit c0 of a set {c0, c1, c2, c3} of four bits ck (for k=0 to 3) representing all seven listed symbols corresponding to the points pj (for j=1 to 6) is invariant and equal to "1" among the symbols p1, p2, p3, p4, p5 and p6 and is only equal to "0" for symbol p7. The listed symbols thus constitute a statistical population within which the value "0" for bit c0 is underrepresented, which may lead to artificial discrepancies between original and refined probability values related to the listed symbols and produced by successive steps of an interpreting process on the basis of this statistical population, which may in turn disturb the interpreting process and cause decoding errors.

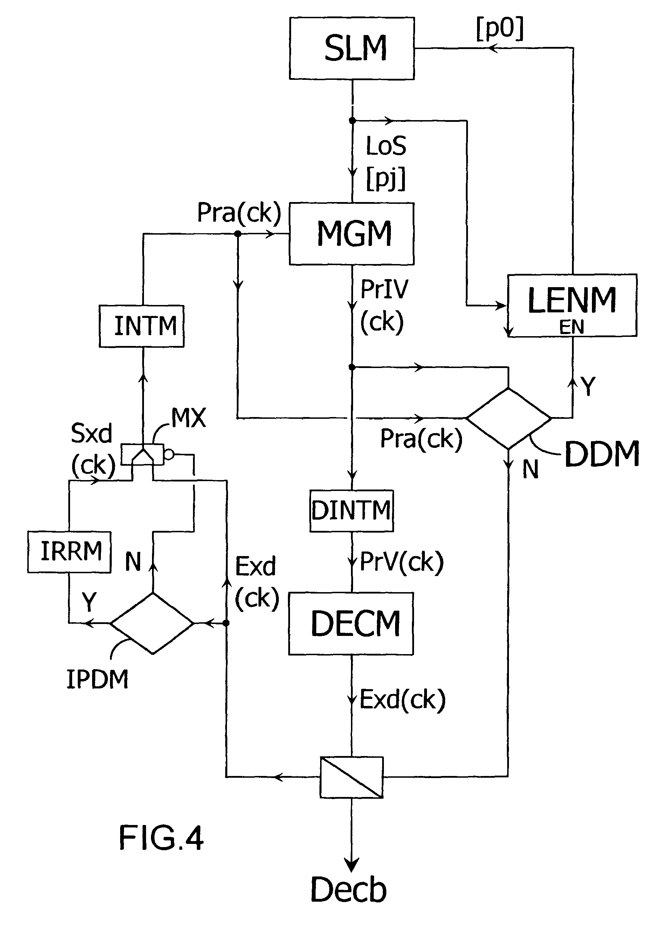

Fig.4 diagrammatically depicts an interpreting method according to an advantageous embodiment of the invention, thanks to which discrepancies between original and refined probability values will be detected and may be suppressed, if said discrepancies stem from artificial causes, by means of corrective interventions, and hence be prevented from disturbing an iterative interpreting process like the one described above.

The method according to the present invention includes:

- symbol listing means SLM for producing, during a symbol listing step, a list LoS of symbols pj,
- marginalization means MGM for processing, during a marginalization step, the symbols included in said list LoS in order to produce an interleaved probability value PrIV(ck) to be associated to each of the bits ck belonging to a same set of bits used for representing all symbols pj,
- de-interleaving means DINTM for transforming, during a de-interleaving step, said interleaved probability values PrIV(ck) into de-interleaved probability values PrV(ck), and
- decoding means DECM for refining, during a decoding step, the de-interleaved probability values PrV(ck) associated to the de-interleaved bits of the symbols included in the list LoS by taking into account knowledge pertaining to an encoding scheme used for encoding the received signal, a refined probability value Exd(ck) related to a given bit ck and produced by the decoding means DECM being intended to be used as an *a priori* probability value Pra(ck) during a subsequent marginalization step after said refined probability value Exd(ck) will have been re-interleaved in the course of an interleaving step carried out by interleaving means INTM.

As known from those skilled in the art, an *a posteriori* probability value APP(ck=1) for the kth bit ck to be equal to 1, and an *a posteriori* probability value APP(ck=0) for the kth bit ck to be equal to 0 may respectively be expressed as follows:

$$APP(ck = 1) = \frac{\pi(ck = 1). \sum\limits_{x \in LoS / ck=1} p(y|x). \prod\limits_{l \neq k} \pi(cl = cl(x))}{\sum\limits_{x \in LoS} p(y|x). \prod\limits_{l} \pi(cl = cl(x))} ,$$

and

$$APP(ck = 0) = 1 - APP(ck = 1) ,$$

where $p(y|x)$ represents a likelihood for receiving y if it is supposed that x has been transmitted, and $\pi(cl=cl(x))$ represents an *a priori* probability that the value of the lth bit cl actually equals that of the lth bit cl of a given symbol x belonging to the list of symbols LoS.

It should further be observed that $\pi(cl=1)=Pra(cl)$ and $\pi(cl=0)=1-Pra(cl)$, Pra(cl) representing an a priori probability value for the value of the lth bit cl to be equal to 1.

An extrinsic probability value for said kth bit ck to be equal to 1, noted XPV(ck=1) and produced by the marginalization means MGM may thus be expressed as follows:

$$XPV(ck = 1) = \frac{\sum\limits_{x \in LoS / ck=1} p(y|x). \prod\limits_{l \neq k} \pi(cl = cl(x))}{\sum\limits_{x \in LoS} p(y|x). \prod\limits_{l \neq k} \pi(cl = cl(x))} ,$$

the use of such extrinsic values for feedback purposes being usually preferred to that of *a posteriori* probability values because an extrinsic value related to a given bit is freed from *a priori* information related to said given bit, which has been used for generating an *a posteriori* value associated with said given bit. In such a case, PrIV(ck)=XPV(ck=1).

The inventors have observed that an interleaved refined probability value Pra(ck) produced by the decoding means DECM in association with a given bit ck may conflict with the interleaved probability value PrIV(ck) associated with said given bit ck by the marginalization means MGM. In other terms, the probability for this bit ck to have a given value may for example appear higher than 0.5 at the end of the marginalization step, whereas the refined probability for this bit to have this same given value will appear lower than 0.5 at the end of the decoding step.

In a situation where the four probability values PrIV(c0), PrIV(c1), PrIV(c2) and PrIV(c3) associated with bits c0, c1, c2 and c3 at the end of the marginalization step are respectively equal to 0.8, 0.7, 0.1 and 0.4, whereas the refined probability values Pra(c0), Pra(c1), Pra(c2) and Pra(c3) are respectively equal to 0.1, 0.6, 0.2 and 0.6, two such discrepancies will have occurred, since Pra(c0)=0.1<0.5<PrIV(c0)=0.8 and PrIV(c3)=0.4<0.5<Pra(c3)=0.6.

Each of these conflicting situations may prevent the iterative interpreting process from converging towards a stable final interpretation of a transmitted symbol, and will for sure lengthen the iterative process since multiple iterations will be required for smoothing out all contradictions. Conflicting situations as described above thus produce significant adverse effects on the performance of the system.

The method according to the invention thus further includes:

- discrepancy detection means DDM for detecting, during a discrepancy detection step, situations in which probability values PrIV(ck) and Pra(ck) associated with a same given bit ck and produced by the marginalization means MGM, on the one hand, and by the decoding means DECM, on the other hand, are respectively smaller than and greater than 0.5 or *vice-versa,* and
- list enlarging means LENM for correcting, during a list enlarging step, a detected discrepancy by adding at least one additional symbol p0 to the list LoS produced by the symbol listing means.

As explained above, discrepancies between original and refined probability values PrIV(ck) and Pra(ck) often originate in an insufficient representation of certain categories of symbols among the listed symbols. The invention thus enables to correct discrepancies by virtue of an increase of the size of the list of symbols LoS constituting the statistical population on the basis of which the probability values PrIV(ck) are computed.

Generally speaking, if Nd bits differ between symbols obtained by taking a hard decision on the basis of the probability values PrIV(ck), on the one hand, and of the refined probability values Pra(ck), a maximum number of $2^{Nd}$ symbols could be added to the list of symbols LoS by the list enlarging means LENM. Since the number $2^{Nd}$ may be too high for a practical and cost-effective implementation, a variant of the invention may embody a limitation measure according to which only the Nmr most relevant discrepancies shall be corrected, i.e. those featuring the Nmr greatest values for the difference |PrIV(ck)-Pra(ck)|. In such an embodiment, the number of symbols p0 to be added to the list of symbols LoS may be limited to Nmr for each corrective iteration by only selecting, for each detected discrepancy, one additional symbol in which only the bit affected by said detected discrepancy will have been complemented.

The maximal *a priori* symbol, obtained by taking a hard decision on the basis of the refined probability values produced in the course of the decoding step may advantageously be systematically added to the list of symbols if said maximal *a priori* symbol isn't already included in said list, as explained hereinafter.

The additional symbol p0 will preferably be obtained by identifying an original symbol for which at least one discrepancy has been detected, in the example described above the original symbol 1100 for which a discrepancy has been detected in relation with a given bit c0, and complementing, within said original symbol 1100, at least said given bit c0, which would give p0=0100, or 0000, 0001, 0010, 0011, 0101, 0110 or 0111, though it is preferable to leave untouched the bits for which no discrepancy has been detected. The symbols which could be added to the list of symbols LoS in order to correct the discrepancy detected in relation with bit c0 are thus 0100 and 0101.

The invention enables to add to the list of symbol LoS at least one non-listed symbol featuring, for the given bit c0, a value corresponding to the refined probability value Pra(ck) produced by the decoding means DECM, which will cause the next probability value PrIV(ck) produced by the marginalization means MGM to converge towards said refined probability value Pra(ck), since the discrepancy detected for bit c0 in this case appears to be caused by an underrepresentation of the value "0" for bit c0 in the listed symbols and thus to have essentially artificial causes, the above corrective process being iterative according to the general principle of the invention depicted here.

It should be noted here that the choice of p0=0101 would simultaneously help to correct the second discrepancy detected in relation with bit c3, since the symbol 0101 also constitutes the maximal *a priori* symbol. This second detected discrepancy was, however, not very significant since the difference between PrIV(c3)=0.4 and Pra(c3)=0.6 is 0.2, and could be smoothed out in subsequent iterations without requiring any corrective intervention.

In the embodiment of the invention depicted here, the list enlarging means LENM may be enabled or disabled by means of a signal received on an enabling input EN, so that the list enlarging step will only be triggered in a situation in which the detected discrepancy appears substantial, e.g. only if a difference between a probability value PrIV(ck) produced by the marginalization means MGM and a corresponding refined probability value Pra(ck) produced by the decoding means DECM exceeds a predetermined threshold Th, for example Th=0.4. In the above example, the discrepancy detection means DDM will observe that |PrIV(c3)-Pra(c3)|=0.2<0.4 and will thus send a "0" towards the enabling input EN of the list enlarging means LENM, so that no list enlarging step will be carried out with the specific purpose to correct the probability values associated with bit c3, though corrective interventions related to other bits like bit c0 may favour the correction of the small discrepancy affecting bit c3. Such selective triggering of the list enlarging step thus enables to save computing time and power.

A prior knowledge of all other symbols of the lattice constellation may also be used for electing the additional symbol to be added to the list of symbols LoS, in order to enhance the performance of the interpreting method according to the invention.

According to a particular embodiment of the invention, an additional symbol p0 to be added to the list [pj] would then be constituted by a particular symbol belonging to a population for which the bit c0 is equal to 0, while being the closest, in the Euclidian or in the Hamming sense, to the original symbol 1100 for which a discrepancy has been detected in relation with a given bit c0.

In the example depicted in Fig.3, the point p5 represents an original symbol 1100 obtained by taking a hard decision on the basis of the probability values PrIV(ck) delivered by the marginalization means MGM, original symbol for which a discrepancy has been detected in relation with a given bit c0. Fig.3 depicts an example in which the lattice constellation LATR is two-dimensional, situation in which a non-already listed symbol for which c0 is equal to 0 and which is closest, in the Euclidian sense, to the symbol p5 can be identified at a relatively low cost in terms of computing power as the symbol 0000. In situations where the lattice constellation LATR involves a high number of dimensions, e.g. several tenths of dimensions, such an identification process will require a huge computing power and is thus unrealistic if it is to be performed by a receiver whose operating energy is produced by a finite battery power source. In such a situation, the search for an additional symbol will first be made in the original lattice constellation LATO as shown in Fig.2, which is known to the receiver. This search will start from the symbol defined by the coordinates (11) and (00), and be performed in a direction of variation of the bit to be complemented, in this example the reverse direction of that indicated by vector AI in Fig.2. The label of the first symbol of the original lattice LATO encountered in this direction, for which the invariant bit c0 has a different value, is represented by a set of bits having a value 0000, which will identify, in the second lattice constellation LATR, the additional symbol p0 to be added to the list [pj].

Though in this particular example, the symbol obtained by using the original lattice constellation LATO is identical to the symbol obtained directly from the two-dimensional lattice constellation LATR, it must be understood that in other situations, the symbols obtained by means of these two different processes may be different from each other.

In the same configuration of the list of symbols depicted in Fig.3, the symbol of the second lattice constellation LATR for which c0 is equal to 0 and which is, in the Hamming sense, closest to the symbol p5 labeled 1100 will be the symbol 0100, since only the bit c0 has to be changed for passing from one to the other. This symbol 0100 would thus represent the additional symbol p0 to be added to the list [pj], if only the Hamming criterion were considered.

It should also be noted that an additional symbol generated as described above will preferably not be actually added to an existing list of symbols which happens to already include said additional symbol.

In the embodiment of the invention shown here, the above-described interpreting method further includes :

- integer refined probability detection means IPDM for detecting, during an integer refined probability detection step, situations in which at least one refined probability value Exd(ck) produced by the decoding step DS is an integer value, and

- thresholding means IRRM for replacing, during a thresholding step, such an integer refined probability value Exd(ck) by a predetermined non-integer threshold value Sxd(ck).

The threshold value Sxd(ck) may for example be chosen equal to $1-\delta$ if the refined probability value Exd(ck) is equal to 1 and equal to $\delta$ if the refined probability value Exd(ck) is equal to 0, where $\delta$ is a predetermined non-integer value chosen lower than 0.5, for example $\delta= 10^{-5}$ or $10^{-6}$.

This is represented by means of a multiplexer MX intended to output either the refined probability value Exd(ck) if it has been recognized as a non-integer value by the detection means IPDM (N=1), or the threshold value Sxd(ck) if the refined probability value Exd(ck) has been recognized as an integer value by the detection means IPDM (N=0).

The inventors have observed that the decoding means DM intended to carry out the decoding step may sometimes output an integer refined probability value, even if all probability values provided to said decoding means are of a non-integer nature. Such situations may occur due to approximations which will be made during the computational process leading to the refined probability values. As already explained above, a refined probability value Exd(ck) equal to 0 or to 1 would have an adverse impact on the performance of the iterative interpreting process and lead to errors in the interpretation, which is prevented in this embodiment of the invention thanks to the integer refined probability detection means IPDM and to the thresholding means IRRM.

Though the above description relates to the operation of a receiver in a MIMO telecommunication system, it should be understood that the present invention may be advantageously employed in any kind of telecommunication system in which the identification of a transmitted symbol involves an iterative interpreting process intended to solve an equation of the type: Y=C.B+N, where Y is a vector representative of the received symbol y, B a vector representative of a symbol originally transmitted, C a matrix representative of the channel or channels through which said symbol has been transmitted and N a vector representative of the noise affecting said communication channel or channels.

### Claims

**1.** A method for interpreting at least one signal transmitted by means of at least one transmitting antenna and received by means of at least one receiving antenna, which method includes:

. a symbol (SLM) listing step for producing a list of symbols selected among predetermined symbols which may potentially be received by means of said at least one receiving antenna, each listed symbol being represented by at least one bit,

. a marginalization (MGM) step for processing said listed symbols in order to produce at least one interleaved probability value to be associated to said at least one bit,

. a de-interleaving (DINTM) step for transforming said at least one interleaved probability value into at least one de-interleaved probability value,

. a decoding (DECM) step for refining said at least one de-interleaved probability value by taking into account knowledge pertaining to an encoding scheme used for encoding the received signal, a refined probability value produced in the course of the decoding step being intended to be used, after being interleaved during an interleaving step, as an *a priori* probability value during a subsequent marginalization step,

method **characterised in that** it further includes:

. a discrepancy (DTM) detection step for detecting situations in which probability values associated with a same given bit and produced in the course of the marginalization step, on the one hand, and in the course of the decoding step, on the other hand, are respectively smaller than and greater than 0.5 or *vice-versa,* and
. a list enlarging (LENM) step for correcting a detected discrepancy by adding at least one additional symbol to the list produced by the symbol listing step.

**2.** A method as claimed in claim 1, **characterized in that** a maximal *a priori* symbol, obtained by taking a hard decision on the basis of the refined probability values produced in the course of the decoding step, constitutes an additional symbol to be added to the list produced by the symbol listing step.

**3.** A method as claimed in claim 1, in which said at least one additional symbol is obtained by identifying at least one original symbol for which a discrepancy has been detected in relation with a given bit and complementing, within said original symbol, at least said given bit.

**4.** A method as claimed in claim 3, in which the symbol to be added to the list is constituted by a particular symbol of the lattice constellation belonging to a population for which said given bit features the suitable complemented value, while being the member of said population which is the closest to the original symbol.

**5.** A method as claimed in any one of claims 1 to claim 4, **characterized in that** the list enlarging (LENM) step is to be executed only if a difference between a probability value produced in the course of the marginalization step and a corresponding refined probability value produced in the course of the decoding step exceeds a predetermined threshold.

**6.** A method as claimed in any one of claims 1 to claim 5, **characterized in that** it further includes :

an integer refined probability detection (IPDM) step for detecting situations in which at least one refined probability value produced by the decoding step is an integer value, and
. a thresholding (IRRM) step for replacing such an integer refined probability value by a predetermined non-integer threshold value.

**7.** A method as claimed in claim 6, **characterized in that** the threshold value is equal to $1-\delta$ if the integer refined probability value is 1 and equal to $\delta$ if the integer refined probability value is 0, where $\delta$ is a predetermined non-integer value chosen lower than 0.5.

**8.** A telecommunication system including at least one transmitter provided with at least one transmitting antenna and at least one receiver provided with at least one receiving antenna, which receiver includes:

. symbol (SLM) listing means for producing a list of symbols selected among predetermined symbols which may potentially be received by means of said at least one receiving antenna, each listed symbol being represented by at least one bit,
. marginalization (MGM) means for processing said listed symbols in order to produce at least one interleaved probability value to be associated to said at least one bit,
. de-interleaving (DINTM) means for transforming said at least one interleaved probability value into at least one de-interleaved probability value,
. decoding (DECM) means for refining said at least one de-interleaved probability value by taking into account knowledge pertaining to an encoding scheme used for encoding the received signal, a refined probability value produced in the course of the decoding step being intended to be used, after being interleaved during an interleaving step, as an *a priori* probability value during a subsequent marginalization step,

telecommunication system **characterized in that** the receiver further includes:

. discrepancy (DTM) detection means for detecting situations in which probability values associated with a same given bit and produced by the marginalization means, on the one hand, and by the decoding means, on the other hand, are respectively smaller than and greater than 0.5 or *vice-versa,* and
. list enlarging (LENM) means for correcting a detected discrepancy by adding at least one additional symbol to the list produced by the symbol listing means.

**9.** A communication device provided with at least one receiving antenna and including:

. symbol (SLM) listing means for producing a list of symbols selected among predetermined symbols which may potentially be received by means of said at least one receiving antenna, each listed symbol being represented by at least one bit,

. marginalization (MGM) means for processing said listed symbols in order to produce at least one interleaved probability value to be associated to said at least one bit,

. de-interleaving (DINTM) means for transforming said at least one interleaved probability value into at least one de-interleaved probability value,

. decoding (DECM) means for refining said at least one probability value by taking into account knowledge pertaining to an encoding scheme used for encoding the received signal, a refined probability value produced in the course of the decoding step being intended to be used, after being interleaved during an interleaving step, as an *a priori* probability value during a subsequent marginalization step,

which communication device further includes:

. discrepancy (DTM) detection means for detecting situations in which probability values associated with a same given bit and produced by the marginalization means, on the one hand, and by the decoding means, on the other hand, are respectively smaller than and greater than 0.5 or *vice-versa,* and

. list (LENM) enlarging means for correcting a detected discrepancy by adding at least one additional symbol to the list produced by the symbol listing means.

**Patentansprüche**

1. Verfahren zum Interpretieren von wenigstens einem mittels wenigstens einer Senderantenne gesendeten und mittels wenigstens einer Empfangsantenne empfangenen Signal, welches Verfahren Folgendes enthält:

. einen Symbol-(SLM-)Auflistungsschritt zum Erzeugen einer Liste von Symbolen, die unter vorbestimmten Symbolen ausgewählt sind, die potentiell mittels der wenigstens einen Empfangsantenne empfangen werden können, wobei jedes aufgelistete Symbol durch wenigstens ein Bit dargestellt bzw. repräsentiert wird,

. einen Marginalisierungs-(MGM-)Schritt zum Verarbeiten der aufgelisteten Symbole, um wenigstens einen verschachtelten Wahrscheinlichkeitswert zu erzeugen, um mit dem wenigstens einen Bit verbunden zu werden,

. einen Entschachtelungs-(DINTM-)Schritt zum Transformieren des wenigstens einen verschachtelten Wahrscheinlichkeitswerts in wenigstens einen entschachtelten Wahrscheinlichkeitswert,

. einen Decodier-(DECM-)Schritt zum Verfeinern des wenigstens einen entschachtelten Wahrscheinlichkeitswerts durch Berücksichtigen eines Wissens, das zu einem Codierschema gehört, das zum Codieren des empfangenen Signals verwendet wird, wobei beabsichtigt ist, dass ein im Verlauf des Decodierschritts erzeugter verfeinerter Wahrscheinlichkeitswert, nachdem er während eines Verschachtelungsschritts verschachtelt ist, während eines nachfolgenden Marginalisierungsschritts als a-priori-Wahrscheinlichkeitswert verwendet wird,

welches Verfahren **dadurch gekennzeichnet ist, dass** es weiterhin Folgendes enthält:

. einen Diskrepanz-(DTM-)Erfassungsschritt zum Erfassen von Situationen, in welchen Wahrscheinlichkeitswerte, die zu einem selben gegebenen Bit gehören und einerseits im Verlauf des Marginalisierungsschritts und andererseits im Verlauf des Decodierschritts erzeugt sind, jeweils kleiner als und größer als 0,5 oder umgekehrt sind, und

. einen Listenvergrößerungs-(LENM-)Schritt zum Korrigieren einer erfassten Diskrepanz durch Hinzufügen wenigstens eines zusätzlichen Symbols zu der durch den Schritt zum Auflisten von Symbolen erzeugten Liste.

2. Verfahren nach Anspruch 1, **dadurch gekennzeichnet, dass** ein maximales a-priori-Symbol, das durch Vornehmen einer harten Entscheidung auf der Basis der verfeinerten Wahrscheinlichkeitswerte erhalten ist, die im Verlauf des Decodierschritts erzeugt sind, ein zusätzliches Symbol bildet, um zu der durch den Symbolauflistungsschritt erzeugten Liste hinzugefügt zu werden.

3. Verfahren nach Anspruch 1, wobei das wenigstens eine zusätzliche Symbol durch Identifizieren wenigstens eines ursprünglichen Symbols erhalten wird, für welches eine Diskrepanz in Bezug auf ein gegebenes Bit erfasst worden ist, und durch Ergänzen wenigstens des gegebenen Bits innerhalb des ursprünglichen Symbols.

4. Verfahren nach Anspruch 3, wobei das zu der Liste hinzuzufügende Symbol durch ein bestimmtes Symbol der Gitterkonstellation, die zu einer Gesamtheit gehört, für welche das gegebene Bit den geeigneten ergänzten Wert charakterisiert, gebildet wird, während es das Element der Gesamtheit ist, das dem ursprünglichen Symbol am nächsten ist.

**5.** Verfahren nach einem der Ansprüche 1 bis 4, **dadurch gekennzeichnet, dass** der Listenvergrößerungs-(LENM-) Schritt nur auszuführen ist, wenn eine Differenz zwischen einem im Verlauf des Marginalisierungsschritts erzeugten Wahrscheinlichkeitswert und einem entsprechenden im Verlauf des Decodierschritts erzeugten verfeinerten Wahrscheinlichkeitswert eine vorbestimmte Schwelle übersteigt.

**6.** Verfahren nach einem der Ansprüche 1 bis 5, **dadurch gekennzeichnet, dass** es weiterhin folgendes enthält:

. einen Schritt zur Erfassung einer ganzzahligen verfeinerten Wahrscheinlichkeit (IPDM) zum Erfassen von Situationen, in welchen wenigstens ein durch den Decodierschritt erzeugter verfeinerter Wahrscheinlichkeitswert ein ganzzahliger Wert ist, und

. einen Schwellenbildungs-(IRRM-)Schritt zum Ersetzen eines solchen ganzzahligen verfeinerten Wahrscheinlichkeitswerts durch einen vorbestimmten nicht ganzzahligen Schwellenwert.

**7.** Verfahren nach Anspruch 6, **dadurch gekennzeichnet, dass** der Schwellenwert gleich $1 - \delta$ ist, wenn der ganzzahlige verfeinerte Wahrscheinlichkeitswert 1 ist, und gleich $\delta$ ist, wenn der ganzzahlige verfeinerte Wahrscheinlichkeitswert 0 ist, wobei $\delta$ ein vorbestimmter nicht ganzzahliger Wert ist, der kleiner als 0,5 gewählt ist.

**8.** Telekommunikationssystem mit wenigstens einem Sender, der mit wenigstens einer Sendeantenne versehen ist, und wenigstens einem Empfänger, der mit wenigstens einer Empfangsantenne versehen ist, welcher Empfänger folgendes enthält:

. eine Symbol-(SLM-)Auflistungseinrichtung zum Erzeugen einer Liste von Symbolen, die unter vorbestimmten Symbolen ausgewählt sind, die potentiell mittels der wenigstens einen Empfangsantenne empfangen werden können, wobei jedes aufgelistete Symbol durch wenigstens ein Bit dargestellt bzw. repräsentiert wird,

. eine Marginalisierungs-(MGM-)Einrichtung zum Verarbeiten der aufgelisteten Symbole, um wenigstens einen verschachtelten Wahrscheinlichkeitswert zu erzeugen, um mit dem wenigstens einen Bit verbunden zu werden,

. eine Entschachtelungs-(DINTM-)Einrichtung zum Transformieren des wenigstens einen verschachtelten Wahrscheinlichkeitswerts in wenigstens einen entschachtelten Wahrscheinlichkeitswert,

. eine Decodier-(DECM-)Einrichtung zum Verfeinern des wenigstens einen entschachtelten Wahrscheinlichkeitswert unter Berücksichtigung eines Wissens, das zu einem Codierschema gehört, das zum Codieren des empfangenen Signals verwendet wird, wobei beabsichtigt ist, dass ein im Verlauf des Decodierschritts erzeugter verfeinerter Wahrscheinlichkeitswert, nachdem er während eines Verschachtelungsschritts verschachtelt ist, während eines nachfolgenden Maginalisierungsschritts als a-priori-Wahrscheinlichkeitswert verwendet wird,

wobei das Telekommunikationssystem **dadurch gekennzeichnet ist, dass** der Empfänger weiterhin folgendes enthält:

. eine Diskrepanz-(DTM-)Erfassungseinrichtung zum Erfassen von Situationen, in welchen Wahrscheinlichkeitswerte, die zu einem selben gegebenen Bit gehören und die einerseits durch die Marginalisierungseinrichtung und andererseits durch die Decodiereinrichtung erzeugt sind, jeweils kleiner als und größer als 0,5 oder umgekehrt sind, und

. eine Listenvergrößerungs-(LENM-)Einrichtung zum Korrigieren einer erfassten Diskrepanz durch Hinzufügen wenigstens eines zusätzlichen Symbols zu der durch die Symbolauflistungseinrichtung erzeugten Liste.

**9.** Kommunikationsvorrichtung, die mit wenigstens einer Empfangsantenne versehen ist und folgendes enthält:

. eine Symbol-(SLM-)Auflistungseinrichtung zum Erzeugen einer Liste von Symbolen, die unter vorbestimmten Symbolen ausgewählt sind, die potentiell mittels der wenigstens einen Empfangsantenne empfangen werden können, wobei jedes aufgelistete Symbol durch wenigstens ein Bit dargestellt bzw. repräsentiert wird,

. eine Marginalisierungs-(MGM-)Einrichtung zum Verarbeiten der aufgelisteten Symbole, um wenigstens einen verschachtelten Wahrscheinlichkeitswert zu erzeugen, um mit dem wenigstens einen Bit verbunden zu werden,

. eine Entschachtelungs-(DINTM-)Einrichtung zum Transformieren des wenigstens einen verschachtelten Wahrscheinlichkeitswerts in wenigstens einen entschachtelten Wahrscheinlichkeitswert,

. eine Decodier-(DECM-)Einrichtung zum Verfeinern des wenigstens einen Wahrscheinlichkeitswerts unter Berücksichtigen eines Wissens, das zu einem Codierschema gehört, das zum Codieren des empfangenen Signals verwendet wird, wobei beabsichtigt ist, dass ein im Verlauf des Decodierschritts erzeugter verfeinerter Wahrscheinlichkeitswert, nachdem er während eines Verschachtelungsschritts verschachtelt ist, während eines nachfolgenden Marginalisierungsschritts als a-priori-Wahrscheinlichkeitswert verwendet wird,

welche Kommunikationsvorrichtung weiterhin folgendes enthält:

. eine Diskrepanz-(DTM-)Erfassungseinrichtung zum Erfassen von Situationen, in welchen Wahrscheinlichkeitswerte, die zu einem selben gegebenen Bit gehören und die einerseits durch die Marginalisierungseinrichtung und andererseits durch die Decodiereinrichtung erzeugt sind, jeweils kleiner als und größer als 0,5 oder umgekehrt sind, und
. eine Listen-(LENM-)Vergrößerungseinrichtung zum Korrigieren einer erfassten Diskrepanz durch Hinzufügen wenigstens eines zusätzlichen Symbols zu der durch die Symbolauflistungseinrichtung erzeugten Liste.

### Revendications

1. Procédé permettant de faire l'interprétation d'au moins un signal émis au moyen d'au moins une première antenne d'émission et reçu au moyen d'au moins une première antenne de réception, lequel procédé inclut :

   - une étape de listage de symboles (SLM) pour établir une liste de symboles choisis parmi des symboles prédéterminés qui peuvent être potentiellement reçus au moyen de ladite au moins première antenne de réception, chaque symbole listé étant représenté par au moins un premier bit,
   - une étape de marginalisation (MGM) pour traiter lesdits symboles listés afin de produire au moins une première valeur de probabilité entrelacée à associer audit au moins premier bit,
   - une étape de désentrelacement (DINTM) pour transformer ladite au moins première valeur de probabilité entrelacée en au moins une première valeur de probabilité désentrelacée,
   - une étape de décodage (DECM) pour affiner ladite au moins première valeur de probabilité désentrelacée en prenant en compte le savoir appartenant à un schéma de codage utilisé pour coder le signal reçu, une valeur de probabilité affinée produite au cours de l'étape de décodage étant prévue pour être utilisée, après entrelacement durant une étape d'entrelacement, comme valeur de probabilité *à priori* durant une étape de marginalisation ultérieure ;

   procédé **caractérisé en ce qu'**il comprend de plus :

   une étape de détection de divergence (DTM) pour détecter des situations dans lesquelles les valeurs de probabilité associées à un même bit donné et produites au cours de l'étape de marginalisation, d'une part, et au cours de l'étape de décodage,
   d'autre part, sont respectivement inférieures et supérieures à 0,5 ou *vice-versa,* et une étape d'agrandissement de liste (LENM) pour corriger une divergence détectée en ajoutant au moins un symbole supplémentaire à la liste produite à l'étape de listage de symboles.

2. Procédé selon la revendication 1, **caractérisé en ce qu'**un symbole *à priori* maximal, obtenu en prenant une décision sévère sur la base des valeurs de probabilité affinées produites au cours de l'étape de décodage, constitue un symbole supplémentaire à ajouter à la liste produite au cours de l'étape de listage de symboles.

3. Procédé selon la revendication 1, dans lequel ledit au moins premier symbole supplémentaire est obtenu en identifiant au moins un symbole initial pour lequel la divergence a été détectée en relation avec un bit donné et en faisant le complément, à l'intérieur dudit symbole initial, au moins dudit bit donné.

4. Procédé selon la revendication 3, dans lequel le symbole à ajouter à la liste est constitué d'un symbole particulier de la constellation en réseau appartenant à une population pour laquelle ledit bit donné caractérise la valeur complémentée appropriée, tout en étant l'élément de ladite population qui est le plus proche du symbole initial.

5. Procédé selon l'une quelconque des revendications 1 à 4, **caractérisé en ce que** l'étape d'agrandissement de liste (LENM) doit être exécutée seulement si une différence entre une valeur de probabilité produite au cours de l'étape de marginalisation et une valeur de probabilité affinée correspondante produite au cours de l'étape de décodage dépasse un seuil prédéterminé.

6. Procédé selon l'une quelconque des revendications 1 à 5, **caractérisé en ce qu'**il inclut de plus :

- une étape de détection de probabilité affinée à nombre entier (IPDM) pour détecter des situations dans lesquelles au moins une première valeur de probabilité affinée produite par l'étape de décodage est une valeur entière, et
- une étape de fixation de seuil (IRRM) pour remplacer une telle valeur de probabilité affinée entière par une valeur de seuil prédéterminée non entière.

7. Procédé selon la revendication 6, **caractérisé en ce que** la valeur de seuil est égale à 1-δ si la valeur de probabilité affinée entière est 1 et égale à δ si la valeur de probabilité affinée entière est 0, où δ est une valeur prédéterminée non entière choisie inférieure à 0,5.

8. Système de télécommunication incluant au moins un émetteur muni d'au moins une première antenne d'émission et au moins un récepteur muni d'au moins une première antenne de réception, lequel récepteur inclut :

- des moyens de listage de symboles (SLM) pour produire une liste de symboles choisis parmi des symboles prédéterminés qui peuvent être potentiellement reçus au moyen de ladite au moins première antenne de réception, chaque symbole listé étant représenté par au moins un premier bit,
- des moyens de marginalisation (MGM) pour traiter lesdits symboles listés afin de produire au moins une première valeur de probabilité entrelacée à associer audit au moins premier bit,
- des moyens de désentrelacement (DINTM) pour transformer ladite au moins première valeur de probabilité entrelacée en au moins une première valeur de probabilité désentrelacée,
- des moyens de décodage (DECM) pour affiner ladite au moins première valeur de probabilité désentrelacée en prenant en compte le savoir appartenant à un schéma de codage utilisé pour coder le signal reçu, une valeur de probabilité affinée produite au cours de l'étape de décodage étant prévue pour être utilisée, après entrelacement durant une étape d'entrelacement, comme valeur de probabilité *à priori* durant une étape de marginalisation ultérieure;

système de télécommunication **caractérisé en ce que** le récepteur comprend de plus :

- des moyens de détection de divergence (DTM) pour détecter des situations dans lesquelles les valeurs de probabilité associées à un même bit donné et produites par les moyens de marginalisation, d'une part, et par les moyens de décodage, d'autre part, sont respectivement inférieures et supérieures à 0,5 ou *vice-versa,* et
- des moyens d'agrandissement de liste (LENM) pour corriger une divergence détectée en ajoutant au moins un premier symbole supplémentaire à la liste produite par les moyens de listage de symboles.

9. Dispositif de communication muni d'au moins une première antenne de réception et incluant :

- des moyens de listage de symboles (SLM) pour produire une liste de symboles choisis parmi des symboles prédéterminés qui peuvent être potentiellement reçus au moyen de ladite au moins première antenne de réception, chaque symbole listé étant représenté par au moins un premier bit,
- des moyens de marginalisation (MGM) pour traiter lesdits symboles listés afin de produire au moins une première valeur de probabilité entrelacée à associer audit au moins premier bit,
- des moyens de désentrelacement (DINTM) pour transformer ladite au moins première valeur de probabilité entrelacée en au moins une première valeur de probabilité désentrelacée,
- des moyens de décodage (DECM) pour affiner ladite au moins première valeur de probabilité désentrelacée en prenant en compte le savoir appartenant à un schéma de codage utilisé pour coder le signal reçu, une valeur de probabilité affinée produite au cours de l'étape de décodage étant prévue pour être utilisée, après entrelacement durant une étape d'entrelacement, comme valeur de probabilité *à priori* durant une étape de marginalisation ultérieure ;

lequel dispositif de communication inclut de plus :

des moyens de détection de divergence (DTM) pour détecter des situations dans lesquelles les valeurs de probabilité associées à un même bit donné et produites par les moyens de marginalisation, d'une part, et par les moyens de décodage, d'autre part, sont respectivement inférieures et supérieures à 0,5 ou *vice-versa,* et

- des moyens d'agrandissement de liste (LENM) pour corriger une divergence détectée en ajoutant au moins un premier symbole supplémentaire à la liste produite par les moyens de listage de symboles.

# SYST

Uncb → **CHENC** →Tb→ **INTL** →Pb→ **MAPMD** →Zi→ **SPTENC**  } **TR**

(ta1,ta2...taNt) →

CHNL

## FIG.1

(ra1,ra2...raNr) →

Decb ← **CHDEC** ←PrV(ck)← **DINTL** ←PrIV(ck)← **DET**  } **REC**

SPTDEC

Exd(ck) → **INTR** → Pra(ck)

EP 1 545 038 B1

LATO                                    LATR

○    ⊗    ○    ○              ○    ○    ⊗    ○
          Tx                              y
○    ○    ○    ○              ○    ○    ○    ○

○    ○    ○    ○              ○    ○    ○    ○
A1                           A1r
  ○→   ○   ○   ○                ○→   ○   ○   ○
  A2                           A2r

FIG.2

A1r                    SPH

                              p5      p6
          11                p4  ⊗  y
          10         p1  •    •    p3
                             R      p2
          00         ○    ○    ○    ○        LATR ←
                              p7
          01         ○    ○    ○    ○
                                         → A2r
             01    00    10    11

FIG.3

FIG.4